(19) Europäisches Patentamt
European Patent Office
Office européen des brevets

(11) Publication number: **0 660 398 A1**

(12) **EUROPEAN PATENT APPLICATION**

(21) Application number: **94203701.1**

(22) Date of filing: **20.12.94**

(51) Int. Cl.6: **H01L 23/29**, C08G 59/22, C08G 59/30

(30) Priority: **21.12.93 JP 344666/93**

(43) Date of publication of application: **28.06.95 Bulletin 95/26**

(84) Designated Contracting States: **DE ES FR GB IT NL**

(71) Applicant: **SHELL INTERNATIONALE RESEARCH MAATSCHAPPIJ B.V.**
**Carel van Bylandtlaan 30**
**NL-2596 HR Den Haag (NL)**

(72) Inventor: **Murata,Yasuyuki,c/o Yuka Shell Epoxy KK dept.ADMP**
**Nishiazabu Mitsui Bldg.**
**17-30 Nishiazabu 4-chome**
**Minato-ku,Tokyo 106 (JP)**
Inventor: **Tohriiwa,Norio c/o Yuka Shell Epoxy KK dept.ADMP**
**Nishiazabu Mitsui Bldg.**
**17-30 Nishiazabu 4-chome**
**Minato-ku,Tokyo 106 (JP)**
Inventor: **Nakanishi,Yoshinori c/oYuka Shell Epoxy dept.ADMP**
**Nishiazabu Mitsui Bldg.**
**17-30 Nishiazabu 4-chome**
**Minato-ku,Tokyo 106 (JP)**

(54) **Flame-retardant epoxy resin composition for semiconductor encapsulation.**

(57) A flame-retardant epoxy resin composition for semiconductor encapsulation which comprises a specific brominated epoxy resin (which is obtained by reaction between an epoxy resin (A) containing substantially no halogen atoms and a polyhydric phenol compound (B) containing one or more than one bromine atom per molecule which is connected directly to the aromatic ring), an epoxy resin containing substantially no halogen atoms, a polyhydric phenolic resin hardener, an inorganic filler, and a cure accelerator. The starting material (A) is a reaction product of bisphenol A, bisphenol F, 4,4'-biphenol, or 3,3',5,5'-tetramethyl-4,4'-biphenol and an epihalohydrin, and the starting material (B) is tetrabromobisphenol A.

The epoxy resin composition gives rise to a cured product which exhibits good heat and humidity resistance, contains a limited amount of extractable halogens, and give off only a very small amount of hydrogen bromide due to thermal decomposition. Therefore, it is suitable for semiconductor encapsulation.

EP 0 660 398 A1

The present invention relates to a flame-retardant epoxy resin composition for semiconductor encapsulation which exhibits good thermal stability and retains high heat and humidity resistance.

Making polymeric materials flame-retardant is an important subject, which is stipulated in the JIS standards, the automotive products standards, the electric products standards and the UL standards.

A new application of thermosetting materials is the encapsulation of semiconductor elements (such as IC and LSI), which substitutes for expensive ceramic encapsulation or metal encapsulation. A commonly used material for this purpose is a low-pressure moulding epoxy resin composition. It is required to be flame-retardant.

The resin for encapsulation is subject to high reliability, especially that under humid conditions. In general, the humidity resistance of resin for encapsulation depends greatly on the resin composition, particularly the content of ionic impurities. Ionic impurities such as sodium ions, chlorine ions, and bromine ions corrode the aluminum wiring while the resin for encapsulation is tested for humidity resistance. The recent manufacturing and purifying techniques have made such a great progress that sodium ions and chlorine ions can be reduced to a low level which has nothing to do with humidity resistance. However, there remains a problem in the conventional flame retardants such as brominated epoxy resin obtained by a reaction between tetrabromobisphenol A or brominated phenol novolak and an epihalohydrin. It is poor in thermal stability and liable to thermal decomposition (which gives rise to bromine ions) at the time of moulding and reflow soldering.

Japanese patent Laid-open No. 39345/1993 discloses a phosphorus-containing epoxy resin which is used as a flame retardant other than brominated epoxy resin. This material, however, is of no practical use because of its insufficient flame retardance and poor heat and humidity resistance.

It is an object of the present invention to provide a flame-retardant epoxy resin composition for semiconductor encapsulation which exhibits high thermal stability as well as high reliability due to good heat and humidity resistance.

The present invention is embodied in a flame-retardant epoxy resin composition for semiconductor encapsulation which comprises

(a) a brominated epoxy resin obtained by reaction between an epoxy resin containing substantially no halogen atoms and a polyhydric phenol compound containing one or more than one bromine atom per molecule which is connected directly to the aromatic ring,
(b) an epoxy resin containing substantially no halogen atoms,
(c) a polyhydric phenolic resin hardener,
(d) an inorganic filler, and
(e) a cure accelerator.

According to the present invention, the epoxy resin composition for semiconductor encapsulation contains as one of its constituents a brominated epoxy resin (a), which is obtained by reaction between an epoxy resin containing substantially no halogen atoms and a polyhydric phenol compound containing one or more than one bromine atom per molecule which is connected directly to the aromatic ring.

The substantially halogen-free epoxy resin as a raw material of the brominated epoxy resin (a) includes, for example, an epoxy resin obtained by reaction between a halogen-free phenol compound or halogen-free amino compound and an epihalohydrin. This epoxy resin should not contain halogen atoms except those originating from trace amounts of halogen-containing impurities due to side reactions. The amount of halogen in impurities is usually less than 1 wt%.

The halogen-free phenol compound as a raw material includes, for example, polyhydric phenols (such as bisphenol A, bisphenol F, resorcin, hydroquinone, biphenol, tetramethylbiphenol, phenol novolak resin, cresol novolak resin, bisphenol A novolak resin, dicyclopentadiene phenol resin, terpene phenol resin, phenol aralkyl resin, and naphthol novolak resin) and polyhydric phenolic resins which are obtained by condensation reaction between a phenol compound and an aldehyde (such as hydroxybenzaldehyde, crotonaldehyde, and glyoxal). The halogen-free amino compound as a raw material includes, for example, diaminophenylmethane, aminophenol, and xylenediamine.

Preferably, among the substantially halogen-free epoxy resins is one which is obtained by reaction between at least one species of phenol compounds selected from bisphenol A, bisphenol F, 4,4'-biphenol, and 3,3',5,5'-tetramethyl-4,4'-biphenol and an epihalohydrin, since it is readily available and gives rise to a desirable cured resin.

The polyhydric phenol compound (containing one or more than one bromine atom per molecule which is connected directly to the aromatic ring) as another raw material of the brominated epoxy resin (a) includes tetrabromohydroquinone, tetrabromobisphenol A, tetrabromobisphenol F, tetrabromo-4,4'-biphenol, and brominated phenol novolak resin. Preferable among these is tetrabromobisphenol A, since it is readily available and gives rise to a desirable cured resin.

Reaction between the epoxy resin and the polyhydric phenol compound should be carried out in a molar ratio of from 1:0.1 to 1:0.8 for the epoxy group in the epoxy resin to the phenolic hydroxyl group in the polyhydric phenol compound. With an excessively small amount of the latter, the resulting brominated epoxy resin (a) does not produce the intended flame retardance due to its low bromine content. With an excessively large amount of the latter, the resulting brominated epoxy resin (a) is too viscous to handle easily.

The reaction between the substantially halogen-free epoxy resin and the polyhydric phenol compound containing one or more than one bromine atom which is connected directly to the aromatic ring may be carried out in the usual way. For example, it may be carried out by melting and mixing the reactants at 100-200 °C for 1-10 hours in the presence of a catalyst. In this way there is obtained the desired brominated epoxy resin (a).

Examples of the reaction catalyst include imidazoles (such as 2-methylimidazole and 2-ethyl-4-methylimidazole), amines (such as 2,4,6-tris(dimethylaminomethyl)phenol and benzyldimethylamine), quaternary ammonium salts (such as tetramethylammonium chloride, tetramethylammonium hydroxide, and benzyltrimethylammonium bromide), phosphines (such as tributylphosphine, triphenylphosphine, and tris-(dimethoxyphenyl)phosphine), phosphonium salts (such as ethyltriphenylphosphonium iodide, ethyltriphenylphosphonium chloride, and tetrabutylphosphonium bromide), alkali metal hydroxides (such as sodium hydroxide and potassium hydroxide), and alkali metal salts (such as sodium hydrogen carbonate and lithium chloride). The reaction catalyst should be used in an amount of 50-1000 ppm for the epoxy resin.

The above-mentioned reaction can be carried out in an inert organic solvent, which includes alcohols (such as ethanol and isopropanol), ketones (such as acetone, methyl ethyl ketone, and methyl isobutyl ketone), aromatic hydrocarbons (such as benzene, toluene, and xylene), ethers (such as dioxane and ethylene glycol dimethyl ether), glycol ethers (such as ethylene glycol monomethyl ether, ethylene glycol monoethyl ether, and propylene glycol monomethyl ether), and aprotic solvents (such as dimethylsulfoxide and dimethylformamide).

The brominated epoxy resin (a) produced as mentioned above varies in structure depending on its starting materials used. It may be represented by the structural formula (I) below if it is produced by reaction between an epoxy resin (as a reaction product of bisphenol A and an epihalohydrin) and tetrabromobisphenol A. It may also be represented by the structural formula (II) below if it is produced by reaction between an epoxy resin (as a reaction product of 3,3',5,5'-tetramethyl-4,4'-biphenol and an epihalohydrin) and tetrabromobisphenol A.

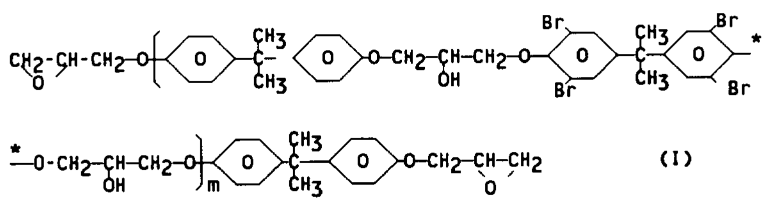

(I)

where m is a number from 0.1 to 5 on average.)

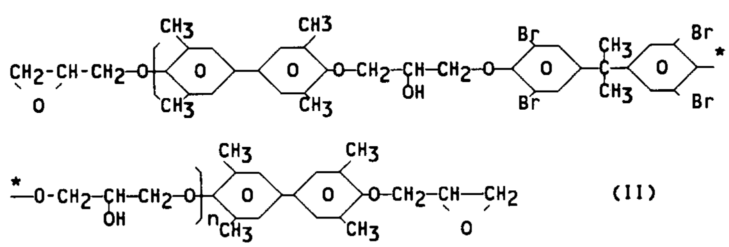

(II)

(where n is a number from 0.1 to 5 on average.)

According to the present invention, the epoxy resin composition should be incorporated with the brominated epoxy resin (a) in such an amount that the total organic components of the resin composition contain 1-10 wt% preferably 2-8 wt%, bromine.

According to the present invention, the epoxy resin composition contains as its constituent an epoxy resin (b) which contains substantially no halogen atoms. Examples of it include such substantially halogen-free epoxy resins as exemplified above as the starting material of the brominated epoxy resin (a). Preferable among them are those epoxy resins produced from any of biphenol, tetramethylbiphenol, cresol novolak resin, bisphenol A novolak resin, dicyclopentadiene phenol resin, terpene phenol resin, and naphthol novolak resin, and an epihalohydrin. They give rise to a desirable cured product.

According to the present invention, the epoxy resin composition should be incorporated with the epoxy resin in such an amount that the brominated epoxy resin (a) and the substantially halogen-free epoxy resin (b) in total account for 5-50 wt%, preferably 5-30 wt%, of the total amount of the epoxy resin composition containing optional components.

According to the present invention, the epoxy resin composition should be incorporated with a polyhydric phenolic resin hardener (c) as a hardener. The polyhydric phenolic resin hardener is a resin having two or more phenolic hydroxyl groups per molecule on average. It includes, for example, phenolic resins (such as phenol novolak resin, cresol novolak resin, bisphenol A novolak resin, biphenol novolak resin, dicyclopentadiene phenolic resin, terpene phenolic resin, phenol aralkyl resin, and naphthol novolak resin) and polyhydric phenolic resins which are obtained by condensation reaction between a phenol compound and an aldehyde (such as hydroxybenzaldehyde, crotonaldehyde, and glyoxal). The amount of the polyhydric phenolic resin hardener (c) should be such that the phenolic hydroxyl groups therein amount to 0.5-2.0 mol, preferably 0.7-1.2 mol, for 1 mol of epoxy groups in all the epoxy resin components.

According to the present invention, the epoxy resin composition should be incorporated with an inorganic filler (d), which includes, for example, fused silica, crystalline silica, glass powder, alumina, and zircon. The amount of the inorganic filler (d) is usually 50-90 wt% of the epoxy resin composition containing optional components.

According to the present invention, the epoxy resin composition should be incorporated with a cure accelerator (e), which includes, for example, imidazoles (such as 2-methylimidazole and 2-ethyl-4-methylimidazole), amines (such as 2,4,6-tris(dimethylaminomethyl)phenol and benzylmethylamine), and organic phosphorus compounds (such as tributylphosphine, triphenylphosphine, and tris(dimethoxyphenyl)-phosphine).

The flame-retardant epoxy resin composition of the present invention can be incorporated with optional components such as coupling agent, plasticizer, and pigment. It can also be incorporated with an optional flame retardant auxiliary, such as antimony trioxide and phosphoric acid.

The flame-retardant epoxy resin composition of the present invention gives off a less amount of bromine ions and gives rise to a better heat- and humidity-resistant cured product than the conventional one. Therefore, it will be advantageously used for semiconductor encapsulation.

## Examples

The invention will be described with reference to the following Referential Examples, Examples, and Comparative Examples.

### Referential Examples 1 to 3

(Production of brominated epoxy resin)

A 3000-ml three-mouth flask equipped with a thermometer, stirrer, and condenser was charged with a substantially halogen-free epoxy resin and a polyhydric phenol compound containing one or more than one bromine atom per molecule which is connected directly to the aromatic ring. The former is any of an epoxy resin ($Q_1$) derived from bisphenol A, an epoxy resin ($Q_2$) derived from bisphenol F, and an epoxy resin ($Q_3$) derived from tetramethylbiphenol. The latter is tetrabromobisphenol A. Their amounts are shown in Table 1. The reactants were heated to 130 °C for uniform dissolution. To the reactants was added 0.5 g of a 50 wt% aqueous solution of tetramethylammonium chloride. The reaction system was gradually heated to 165 °C and was held at that temperature for 3 hours.

After the completion of the reaction, the reaction product was cooled and solidified. Thus there was obtained a brominated epoxy resin. It was tested for epoxy equivalent and bromine content. The results are shown in Table 1.

Table 1

| | | Referential Example No. | | |
|---|---|---|---|---|
| | | 1 | 2 | 3 |
| Manufacturing conditions | Designation of halogen-free epoxy resin * | $Q_1$ | $Q_2$ | $Q_3$ |
| | Amount of halogen-free epoxy resin (g) | 1000 | 1000 | 1000 |
| | Amount of tetrabromobisphenol A (g) | 600 | 600 | 550 |
| Resulting resin | Epoxy equivalent | 512 | 448 | 473 |
| | Bromine content (wt%) | 22 | 22 | 21 |

Note to Table 1

$Q_1$ An epoxy resin derived from bisphenol A ("Epikote 828" having an epoxy equivalent of 186, a product of Yuka Shell Epoxy K.K.)

$Q_2$ An epoxy resin derived from bisphenol F ("Epikote 807" having an epoxy equivalent of 170, a product of Yuka Shell Epoxy K.K.)

$Q_3$ An epoxy resin derived from tetramethylbiphenol ("Epikote YX4000" having an epoxy equivalent of 186, a product of Yuka Shell Epoxy K.K.)

Examples 1 to 4 and Comparative Examples 1 to 4

Several epoxy resin compositions were prepared according to the formulation shone in Table 2. The substantially halogen-free epoxy resin is o-cresol novolak epoxy resin ($Q_4$) or epoxy resin ($Q_5$) derived from tetramethylbiphenol. The bromine- or phosphorus-containing epoxy resin is any one of the epoxy resins obtained in Referential Examples, brominated phenol novolak epoxy resin ($R_1$), or phosphorus-containing epoxy resin ($R_2$). The polyhydric phenolic resin hardener is phenol novolak resin. The inorganic filler is silica powder. The curing accelerator is triphenylphosphine. The flame retardant auxiliary is antimony trioxide. The release agent is carnauba wax. The surface treatment (coupling agent) for the filler (silica powder silane.

The composition underwent roll mixing at 80-130 °C for 5 minutes, followed by sheeting, cooling, and crushing into a moulding material.

The moulding material was formed into a test piece by low-pressure transfer moulding, with the mould temperature being 180 °C and the moulding time being 180 seconds. The test piece was postcured at 180 °C for 8 hours. The postcured test piece was tested for glass transition temperature, extractable halogen, hydrogen bromide due to thermal decomposition, and flame retardance. The results are shown in Table 2.

Table 2

| Example No. (Comparative Example No.) | | 1 | 2 | 3 | 4 | (1) | (2) | (3) |
|---|---|---|---|---|---|---|---|---|
| Epoxy resin composition (pbw) | Halogen-free epoxy resin (amount pbw) | $Q_4$ *11<br>100 | $Q_4$ *11<br>100 | $Q_4$ *11<br>100 | $Q_4$ *11<br>100 | $Q_5$ *12<br>100 | $Q_4$ *11<br>100 | $Q_4$ *11<br>100 |
| | Bromine- or phosphorus-containing epoxy resin (amount pbw) | Ref. Ex. 1<br>27 | Ref. Ex. 2<br>27 | Ref. Ex. 3<br>28 | Ref. Ex. 1<br>27 | $R_1$ *13<br>15 | $R_2$ *14<br>30 | - |
| | Phenol novolak resin *1 | 57 | 57 | 57 | 61 | 57 | 66 | 61 |
| | Silica powder *2 | 460 | 460 | 462 | 469 | 431 | 488 | 478 |
| | Triphenylphosphine *3 | 1 | 1 | 1 | 1 | 1 | 1 | 1 |
| | Antimony trioxide *4 | 10 | 10 | 10 | 10 | 10 | 10 | 10 |
| | Carnauba wax *5 | 1 | 1 | 1 | 1 | 1 | 1 | 1 |
| | Epoxy silane *6 | 1 | 1 | 1 | 1 | 1 | 1 | 1 |
| Properties of cured resin | Glass transition point (°C) *7 | 157 | 153 | 158 | 149 | 160 | 131 | 157 |
| | Extractable halogen (ppm) *8<br>$Cl^-$<br>$Br^-$ | 5<br>27 | 7<br>36 | 4<br>23 | 5<br>24 | 8<br>112 | 6<br><1 | 4<br><1 |
| | HBr due to thermal decomposition (ppm) *9 | 1.9 | 2.0 | 1.6 | 1.7 | 6.8 | <1 | <1 |
| | Flame retardance *10 | V-0 | V-0 | V-0 | V-0 | V-0 | V-1 | HB |

Note to Table 2

*1 Polyhydric phenolic resin hardener, with a softening point of 85 °C, from Gunei Kagaku

*2 Inorganic filler, "RD-8", from Tatsumori

*3 Cure accelerator

*4 Flame retardant auxiliary

*5 Release agent

*6 Coupling agent, "KBM-403", from Shinetsu Chemical

*7 Obtained from the thermal expansion curve by thermomechanical analysis (TMA)

*8 Determined by ion chromatograhpy after extraction with hot water at 180 °C for 12 hours.

*9 Determined by ion chormatography after absorption by hydrogen peroxide, with the sample heated at 200 °C for 24 hours.

*10 Evaluated by vertical burning in accordance with UL-94 standard

*11 ($Q_4$) o-Cresol novolak epoxy resin ("Epikote 180H65" with an epoxy equivalent 201, from Yuka Shell Epoxy)

*12 ($Q_5$) Epoxy resin derived from tetramethylbiphenol ("Epikote YX4000H" with an epoxy equivalent 193, from Yuka Shell Epoxy)

*13 ($R_1$) Brominated phenol novolak epoxy resin ("BREN S" with an epoxy equivalent 285 and a bromine content 36 wt%, from Nippon Kayaku)

*14 ($R_2$) Phosphorus-containing epoxy resin ("PPQ-EX" with an epoxy equivalent 214 and a phosphorus content 7.3 wt%, from Hokko Kagaku)

It is apparent from Table 2 that the cured resins in Examples 1 to 4 contain a less amount of extractable halogen and give off a less amount of hydrogen bromide due to thermal decomposition as compared with the one in Comparative Example 1. All of them exhibit good flame retardance. The sample in Comparative Example 2 (which is incorporated with a phosphorus-containing epoxy resin in place of a bromine-containing epoxy resin) and the sample in Comparative Example 3 (which is not incorporated with a bromine-containing epoxy resin) contain a small amount of extractable halogen and give off a small amount of hydrogen bromide due to thermal decomposition. However, the former is poor in flame retardance and heat resistance (in terms of glass transition point), and the latter is extremely poor in flame retardance.

[Effect of the invention]

The epoxy resin composition of the present invention gives rise to a cured product which exhibits good heat and humidity resistance, contains a limited amount of extractable halogens, and gives off only a very small amount of hydrogen bromide due to thermal decomposition. Therefore, it will be advantageously used for semiconductor encapsulation.

## Claims

1. A flame-retardant epoxy resin composition comprising
   (a) a brominated epoxy resin obtained by reaction between an epoxy resin containing substantially no halogen atoms and a polyhydric phenol compound containing one or more than one bromine atom per molecule which is connected directly to the aromatic ring,
   (b) an epoxy resin containing substantially no halogen atoms,
   (c) a polyhydric phenolic resin hardener,
   (d) an inorganic filler, and
   (e) a cure accelerator.

2. An epoxy resin composition as defined in claim 1, wherein the brominated epoxy resin (a) is one which is obtained by reaction between:
   . an epoxy resin which is obtained by reaction between at least one compound selected from bisphenol A, bisphenol F, 4,4'-biphenol and 3,3',5,5'-tetramethyl-4,4'-biphenol and an epihalohydrin, and
   . a polyhydric phenol compound which contains one or more than bromine atom per molecule which is connected directly to the aromatic ring.

3. An epoxy resin composition as defined in claim 1 or 2, wherein the brominated epoxy resin (a) is one which is obtained by reaction between an epoxy resin containing substantially no halogen atoms and tetrabromobisphenol A.

4. An epoxy resin composition as defined in any of claims 1 to 3, wherein the epoxy resin (b) containing substantially no halogen atoms is one which is obtained by reaction between at least one species of phenol compound selected from biphenol, tetramethylbiphenol, and cresol novolak and an epi-halohydrin.

European Patent Office

# EUROPEAN SEARCH REPORT

Application Number
EP 94 20 3701

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | EP-A-0 264 705 (DOW CHEMICAL CO) 27 April 1988<br>* the whole document *<br>--- | 1 | H01L23/29<br>C08G59/22<br>C08G59/30 |
| Y<br><br><br><br>A | PATENT ABSTRACTS OF JAPAN<br>vol. 015 no. 450 (C-0885) ,15 November 1991<br>& JP-A-03 192112 (MITSUI PETROCHEM IND LTD) 22 August 1991,<br>* abstract *<br>--- | 1<br><br><br><br>2,3 | |
| A | EP-A-0 459 591 (SHELL INT RESEARCH) 4 December 1991<br>* the whole document *<br>--- | 1 | |
| A | PATENT ABSTRACTS OF JAPAN<br>vol. 013 no. 556 (C-664) ,11 December 1989<br>& JP-A-01 230619 (YUKA SHELL EPOXY KK) 14 September 1989,<br>* abstract *<br>--- | 1 | |
| | | | TECHNICAL FIELDS SEARCHED (Int.Cl.6) |
| A | US-A-4 965 657 (OGATA MASATSUGU ET AL) 23 October 1990<br>* the whole document *<br>--- | 1 | H01L<br>C08G |
| A | US-A-5 250 637 (SHIOBARA TOSHIO ET AL) 5 October 1993<br>* the whole document *<br>--- | 1 | |
| A | EP-A-0 324 389 (DOW CHEMICAL CO) 19 July 1989<br>* the whole document *<br>--- | 1 | |
| A | GB-A-1 087 339 (WESTINGHOUSE ELECTRIC CORP)<br>* the whole document *<br>---<br>-/-- | 1 | |

The present search report has been drawn up for all claims

| Place of search | Date of completion of the search | Examiner |
|---|---|---|
| THE HAGUE | 12 April 1995 | Zeisler, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

European Patent Office

# EUROPEAN SEARCH REPORT

Application Number
EP 94 20 3701

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | JOURNAL OF APPLIED POLYMER SCIENCE, vol. 33,no. 4, March 1987 NEW YORK US, pages 1173-1185, HEMI NAE 'CURE AND THERMAL PROPERTIES OF BROMINATED EPOXY SYSTEMS' * the whole document * ----- | 1 | |
| | | | TECHNICAL FIELDS SEARCHED (Int.Cl.6) |

The present search report has been drawn up for all claims

| Place of search | Date of completion of the search | Examiner |
|---|---|---|
| THE HAGUE | 12 April 1995 | Zeisler, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document